# EUROPÄISCHE PATENTANMELDUNG

(11) **EP 2 267 817 A1**
(43) Veröffentlichungstag der Anmeldung: **29.12.2010**
(21) Anmeldenummer: 10010431.4
(22) Anmeldetag: 29.09.2008
(51) Int. Cl.: H01L 51/52

(54) **Vorrichtung für die Herstellung und/oder Aufbewahrung von organischen Leuchtdioden bzw. Solarzellen sowie Verfahren zur Herstellung der Vorrichtung**

(30) Priorität: 12.10.2007 DE 102007049293; 29.01.2008 DE 102008006816
(62) Teilanmeldung aus: 08839946.4
(71) Anmelder: 3A Technology & Management AG, 8212 Neuhausen am Rheinfall (CH)
(72) Erfinder: Lohwasser, Wolfgang, 78262 Gailingen (DE); Kiy, Michael, 8404 Winterthur (CH)
(74) Vertreter: Vötsch, Reiner

(57) **Zusammenfassung**

Die Erfindung betrifft eine Vorrichtung für die Herstellung und/oder Aufbewahrung von wasserdampfempfindlichen Elektronikbauteilen, insbesondere von organischen Leuchtdioden oder Solarzellen. Erfindungsgemäß ist eine mehrfache Einkapselung -- insbesondere durch eine doppelte Einkapselung -- vorgesehen, welche eine innere Einkapselung für die Elektronikbauteile ergibt. Eine äußere Einkapselung bildet einen Hohlraum (34), der neben dem/den sich in der zweiten Einkapselung befindlichen Elektronikbauteil/en (30) Feuchtigkeitsabsorberwerkstoff (28) enthält. Jener -- bevorzugt durch zumindest eine Noppe oder wenigstens einen Steg (16) gebildete -- Hohlraum (34) ist mit inertem Gas gefüllt, oder er enthält eine Flüssigkeit bzw. einen Festkörper hoher Wasserdampfleitfähigkeit.

## Beschreibung

Die Erfindung betrifft eine Vorrichtung für die Herstellung und/oder Aufbewahrung von wasserdampfempfindlichen Elektronikbauteilen, insbesondere von organischen Leuchtdioden oder Solarzellen, nach dem Oberbegriff des Anspruchs 1. Zudem erfasst die Erfindung ein Verfahren zum Herstellen dieser Vorrichtung.

Als OLED -- nämlich als eine "organic light-emitting diode" -- wird eine als dünnfilmiges, leuchtendes Bauelement aus organischen, halbleitenden werkstoffen gestaltete, mehrere organische Schichten umfassende Leuchtdiode bezeichnet. Diese ist bevorzugt für Bildschirmeinsätze oder für Raumbeleuchtungen vorgesehen und kann als in sich biegsames Display eingesetzt werden.

Um den Bauteilen der organischen Elektronik eine Lebensdauer von mehreren Jahren zu ermöglichen, werden sie zwischen zwei Glassscheiben eingekapselt; diese sollen Wasserdampfbarrieren bilden. Nachteilig bleibt bei diesen neben einem hohen Gewicht, dass mit ihnen eine kostengünstige Rolle-zu-Rolle-Produktion nicht durchgängig möglich ist, dass sie nicht biegbar sind und leicht brechen, weshalb sie vor Erschütterungen geschützt werden müssen.

Es wurden auch flexible Verkapselungsmaterialien aus sog. Multilayern für flexible OLEDs vorgeschlagen, auch relativ dicke -- gegebenenfalls aus mehreren Lagen bestehende-PECVD-Schichten zur Einkapselung von flexiblen OLEDs. Alle diese Materialien lassen sich heute nicht mit vertretbarem Aufwand und guter Produktionssicherheit im industriellen Maßstab in genügender Qualität herstellen.

In Kenntnis dieser Gegebenheiten hat sich der Erfinder das Ziel gesetzt, ein Elektronikbauteil ohne die vorstehenden Nachteile anzubieten, das mit dem Stande der Technik entsprechenden Einkapselungsmaterialien eine Lebensdauer von einigen Jahren bis Jahrzehnten aufweist. Insbesondere ist Aufgabe dieser Erfindung die Schaffung eines Einkapselungssystems, das mit großtechnisch heute in der flexiblen Verpackungindustrie verfügbaren kostengünstigen Technologien und Materialien auskommt. Sinnvoll wären zudem Wasserdampfbarrieren mit einer Durchlässigkeit von weniger als 1 10-5 g/(m² 24h).

Zur Lösung dieser Aufgabe führt eine doppelte Einkapselung mit Wasserdampfabsorber des zumeist wasserdampfempfindlichen Elektronikbauteils. Eine äußere Einkapselung bildet dabei einen Hohlraum, der neben der sich in einer zweiten Einkapselung befindlichen OLED auch eine der Lebensdauer angemessene Menge aus Feuchtigkeitsabsorbermaterial enthält. Der Hohlraum ist bevorzugt mit inertem trockenem Gas -- N₂, Ar -- gefüllt, kann aber auch eine Flüssigkeit oder einen Festkörper mit sehr guter Wasserdampfleitfähigkeit enthalten. Von Bedeutung ist, dass im Hohlraum der Wasserdampf wesentlich leichter zu einem Feuchteabsorber fließen kann als durch die zweite Einkapselung zur OLED.

Jegliche gegebenenfalls in die äußere erste Verkapselung eindringende Feuchtigkeit wird von den eingekapselten Feuchteabsorbern absorbiert, bevor sie durch die zweite innere Einkapselung zum eigentlichen OLED kommen kann. Damit wird -- vor dem Aufbrauch der Absorber -- ein völlig trockener Betrieb der OLED gewährleistet.

Der Hohlraum kann durch Noppen oder Stege erzeugt werden, die in eines von zwei folienartigen Deckelementen eingeprägt sind oder durch zusätzlich aufgedruckte oder anderweitig angebrachte Noppen oder Stege. Bei genügend großer Absorptionsgeschwindigkeit des Feuchteabsorbers und genügend guter zweiter Einkapselung der OLED kann als Hohlraum auch ein durch übliche Antiblockpartikel zwischen den beiden Folien entstehender Hohlraum genügen.

Zum Erzeugen des Hohlraums können zudem Abstandshalterauch in transparenter Form -- als Struktur aufgebracht oder in die jeweiligen Folien als anorganische Partikel eingebracht werden.

Vorteilhafterweise besteht die äußere Verkapselung aus flexiblen Barriereverbundfolien; diese lichttransparenten Verbundfolien beinhalten dabei bevorzugt eine anorganische lichtdurchlässige Barriereschicht. Letztere ist insbesondere aus SiOx, wobei x eine Zahl von 1,6-2,0vorzugsweise 2,0 -- bedeutet, kann aber auch aus AlyOz bestehen, wobei y:z eine Zahl von 0,5-1,0 -- bevorzugt ,0,66 -- ist, gegebenenfalls auch aus ZnO, MgO, TiO2, Si3N4, AIN o. dgl.

Die transparenten Schichten werden im Rahmen der Erfindung mittels Vakuumbeschichtungsverfahren -- wie Sputtern, Plasma-CVD (chemical vapor deposition), PVD (physical vapor deposition), thermisches Verdampfen oder Elektronenstrahlverdampfen, vorgenannte Verfahren insbesondere im Vakuum durchgeführt, -- aufgebracht. Besonders bevorzugt wird dabei die Elektronenstrahlverdampfung von Siliziumoxyd. Im übrigen wird diese transparente Folie bei der Einkapselung nur in nicht plastisch verformtem Zustand benutzt.

Zur Verbesserung der Barrierewirkung wird die anorganische Barriereschicht zweckmäßigerweise noch mit einer Lackschicht kombiniert. Besonders bewährt haben sich hierbei Lackschichten auf der Basis von organisch/anorganischen Hybridpolymeren, beispielsweise sogenannten Ormoceren. Aber auch Lacke auf Epoxy-Amin-Basis oder auf der Basis von Polysilazanen sind dafür geeignet.
Um die Sperrwirkung noch weiter zu verbessern, kann man auch mehrere anorganische Schichten durch wechselseitiges Lackieren/Vakuumbeschichten zu sog. Multilayer-Barrierefolien kombinieren. Neben dem Lackieren können die organischen Schichten auch aufgedampft sowie beispielsweise über EB- oder UV-Strahlen vernetzt sein.

Weiterhin kann man auch mehrere mit Barriereschichten beschichtete Folien durch Klebstoffkaschierung zu Verbunden mit höherer Sperrwirkung kombinieren!

Bevorzugt werden die zwei Verbundfolien durch thermische Versiegelung oder durch Ultraschallversiegelung miteinander verbunden. Dazu muss die jeweils zu verbindende Lage der Verbundfolie aus einem passenden Siegelmedium bestehen.

Beispiele von besonders geeigneten Folien mit Sperrwirkung sind EVOH-Folien (Ethylenvinylalkohol), PVcD-Folien (Polyvinylidenchlorid), Folien aus halogeniertem Polyethylen, wie aus chlorierten und/oder fluorierten Polyehtylenen, beispielsweise Polychlorotrifluorethylen (PCTFE), auch bekannt unter dem Markennamen ACLAR, oder Folien aus Acrylnitril/Metacrylat-Copolymeren, auch bekannt unter dem Markennamen BAREX.

Alternativ kann man auch erst eine Einkapselung beispielsweise mittels Spritzgießens von Polymeren oder mittels Thermoformen durchführen und anschließend diese Einkapselung - bevorzugt durch Vakuumverfahren -- mit anorganischen Sperrschichten versehen. Diese Vakuumsperrschichten können dann wiederum mit Lacken zur Barriereverbesserung kombiniert werden. Auch sind wieder sog. Multilayer möglich!

In günstiger Weise benutzt man zur ersten Verkapselung der Rückseite eine Metallverbundfolie, insbesondere eine Aluminiumverbundfolie. In dieser Verbundfolie können auch durch Kaltumformung Kavitäten zur Aufnahme von Feuchteabsobermaterial sowie auch Stege und Noppen als Abstandshalter oder Fixierungselemente für die einzukapselnde zweite OLED enthalten sein. Die in der Fläche vollkommen undurchlässige Verbundfolie kann aber auch direkt mit der OLED verklebt -- oder in anderer Weise verbunden -- sein.

Die Folie kann sogar das Substrat für die eigentliche OLED-Herstellung sein. Wichtig für eine erfindungsgemäße Einkapselung ist, dass zwischen der OLED und der transparenten Oberseitenfolie ein Raum bzw. Hohlraum mit guten Wasserdampftransporteigenschaften und Wasserdampfabsorbermaterial vorhanden ist, so dass die Leuchtfläche nur zu geringem Teil oder gar nicht bedeckt ist.

Die Rückseite kann aber auch durch die oben beschriebenen transparenten Abdeckmaterialien gebildet werden. Da diese nicht zu 100% feuchteundurchlässig sind, muss in diesem Fall wieder gewährleistet werden, dass zwischen der OLED und der Folie die eindringende Folie über einen Hohlraumoder einen Füllstoff mit hohem Feuchteleitvermögen -- zu dem Feuchteabsorbermaterial abgeleitet werden kann.

Bei einer erfindungsgemäßen Ausführungsform wird die äußere Verkapselung wie eine konventionelle Blisterverpackung aufgebaut; der Blister wird durch Kaltumformung aus mehrschichtige folienförmigen Material ausgeformt. Beispiele sind Aluminiumfolien, die beidseitig mit Kunststoffschichten oder einseitig mit Kunststoff und anderseitig mit Lack bedeckt sind. Die Aluminiumfolien liegen beispielsweise in einer Dicke von etwa 7 µm bis 100 µm vor. Die auf einer Seite der Aluminiumfolie angebrachten Kunststoffe sind beispielsweise den Reihen der Polyamide oder der Polyolefine, wie Polyehtylen und Polypropylen, des Polyvinylchlorids, des Polyesters etc. und können durch Extrusion oder als Folien oder Polienverbunde durch Folienkaschierung, fallweise mittels eines Primers und/oder Klebers aufgebracht werden. Auf der anderen Seite der Aluminiumfolie können Kunststoffe der Reihen des Polyvinylchlorids, der Polyolefine, wie Polyethylen oder Polypropylen, der Polyamide, der Polyester und/oder der Cycloolefin-Ethylen-Coplymere etc. durch Extrusion oder als Folien oder Folienverbunde durch Folienkaschierung, fallweise mittels eines Primers und/oder Klebers aufgebracht werden. Die Dicke der Schichten der Extrusionskaschierung oder die Dicke der Folien oder Folienverbunde kann beispielsweise 10 µm bis 100 µm betragen.

Das folienförmige Material enthält dabei Kavitäten, die Wasserdampf-absorbermaterial z. B. in Tablettenform aufnehmen können, außerdem Stege oder Noppen, die eine möglichst freie Lagerung des OLED ermöglichen. Zudem sind der Deckelfolie oder der OLED Noppen, Stege o. dgl. angeformt, die einen Kontakt der transparenten Deckelfolie mit der OLED verhindern. Ziel dieser Anordnung ist es, einen möglichst guten Gasaustausch rund um die OLED zu ermöglichen.

In die innere Polymer/Lack-Schicht der Rückseitenverbundfolie können auch gewisse Mengen von Feuchteabsorbermaterialien eingearbeitet oder auf die Folie aufgebracht sein. Dadurch benötigt man bei genügend guter Dichtigkeit der äußeren Einkapselung keine Kavitäten zur Aufnahme des Feuchteabsorbermaterials und erhält eine wesentlich flexiblere Gesamtstruktur.

Auch ist es oft zweckmäßig, innerhalb der ersten Einkapselung noch weitere -- elektronische -- Komponenten einzubringen, dies besonders dann, wenn man dadurch die Anzahl der Komplexität der elektrischen Verbindungen nach außen durch die Einkapselung hindurch verbessert. Zur zweiten inneren Einkapselung genügen -- je nach Aktivität/Absorptionsgeschwindigkeit der Feuchteabsorber in der äußeren Verkapselung -- auch relativ schwache Barrierematerialien.

Grundsätzlich kommen damit für die innere Einkapselung nahezu alle einigermaßen Feuchte sperrende Materialien in Frage. Insbesondere kann auch eines der Einkapselungsmaterialien als Substrat für das Aufbringen der OLED dienen. Die andere Seite der Einkapselung mag zudem durch eine Vakuumbeschichtung, Lackierung mit einem Barrierelack oder Klebstoffkaschierung mit einer Folie -- Metall und/oder Kunststoff -- erfolgen. Auch eine Kombination der Verfahren ist möglich.

Von erfinderischer Bedeutung ist, dass die Diffusion von Wasserdampf und Sauerstoff in der zweiten Einkapselung um wenigstens zwei Größenordnungen schlechter ist als in dem umgebenden Hohlraum, der mit dem Wasserdampfabsorber in direkter Verbindung steht.

Als günstig hat es sich auch erwiesen, eine OLED-Struktur unter inerter trockener Atmosphäre zu erstellen sowie in dieser Umgebung die erste Verkapselung durchzuführen. Bevorzugt erfolgt dies von Rolle zu Rolle. Die zweite äußere Verkapselung kann dann unter normalen Umgebungsbedingungen erfolgen.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- Fig. 1:: eine offene Frontansicht einer Vorrichtung mit einer in dieser angeordneten organischen Leucht- diode, bzw. einer OLED- Einrichtung;
- Fig. 2:: die teilweise geschnittene Draufsicht auf einen Abschnitt der Vorrichtung nach Fig. 1;
- Fig. 3:: eine Draufsicht auf eine halb flexible Solarzelle, deren Profil etwa jenem nach Fig. 1 entspricht;
- Fig. 4:: die Skizze einer Frontansicht einer anderen Vorrichtung mit einer Diodeneinrichtung;
- Fig. 5:: eine Draufsicht auf einen Abschnitt der Vorrichtung nach Fig. 4.

Eine kastenähnliche Vorrichtung 10 weist ein rinnenartiges Bodenprofil 12 der Querschnittslänge a auf, aus dessen ebener Bodenfläche 14 beidends etwa rechtwinklig zu dieser ein Randsteg 16 der freien Höhe c herausgeformt ist.

Die beiden Randstege 16 liegen jeweils einem -- zu jener Bodenfläche 14 parallelen -- Fußstreifen 18 der Querschnittslänge a₁ neben dessen freier Längskante 19 auf, der Teil eines Längswandprofils 20 der Vorrichtung 10 ist; an den Fußstreifen 18 schließt rechtwinklig vertikal eine streifenartige Wandplatte 22 der Höhe h an, deren oberes Ende von einem ebenfalls zur Wandplatte 22 rechtwinklig nach außen kragenden Firststreifen 24 des Kragmaßes k gebildet wird.

Sowohl das Bodenprofil 12 als auch das -- mit dessen Randsteg 16 einen Rinnenraum 26 rechteckigen Querschnittes der lichten Breite e begrenzende -- Längswandprofil 20 sind aus Blisterwerkstoff geformt.

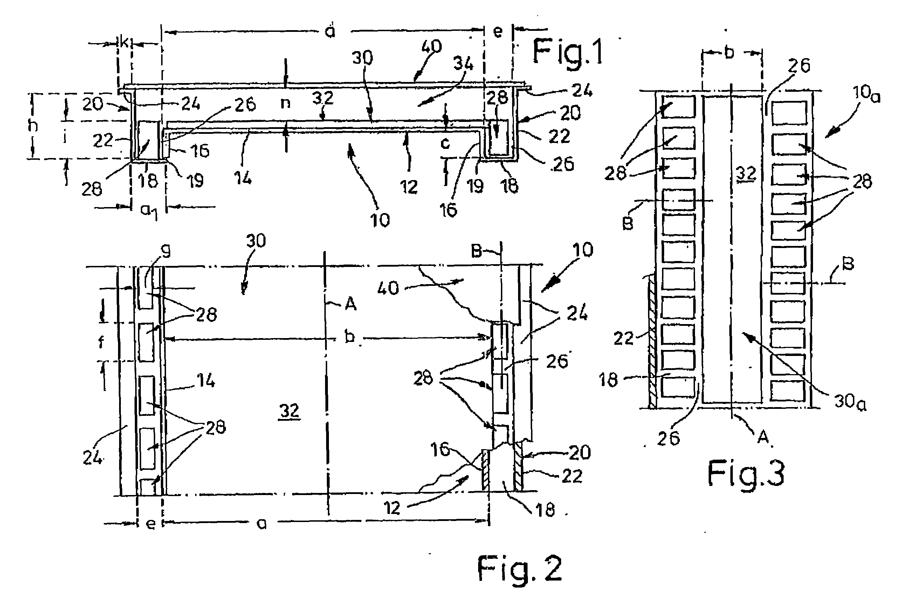

Innerhalb jedes Rinnenraums 26 sind Feuchtigkeitsabsorber 28 -- gemäß Fig. 2 der Länge f und der Breite g -- zur Feuchtigkeitsaufnahme angeordnet, deren Höhe i oberhalb der Bodenfläche 14 endet. Auf letzterer lagert eine Elektronik-oder OLED-Folie 30, die sich von dem in Fig. 1 linken Randsteg 16 des Bodenprofils 12 bis zur rechten Reihe der Feuchtigkeitsabsorber 28 erstreckt.

In vertikalem Abstand n zur Oberfläche 32 der OLED-Folie 30 verläuft horizontal eine transparente Deckelfolie 40, die beidseits auf den Firststreifen 24 aufliegt und nach oben hin einen Firstraum 34 begrenzt.

Der Aufbau der Vorrichtung 10a der Fig. 3 entspricht i.W. der Vorrichtung 10 der Fig. 1, 2, wobei die Längsachsen B der Feuchtigkeitsabsorber 28 hier die Längsachse A der Vorrichtung 10 queren; im Beispiel der Fig. 1, 2 verläuft letztere parallel zu den Längsachsen B der Feuchtigkeitsabsorber 28. Die hier halbflexibel ausgeführte OLED-Folie 30a ist im Vergleich zur OLED-Folie 30 der Fig. 1, 2 von wesentlich geringerer Breite b.

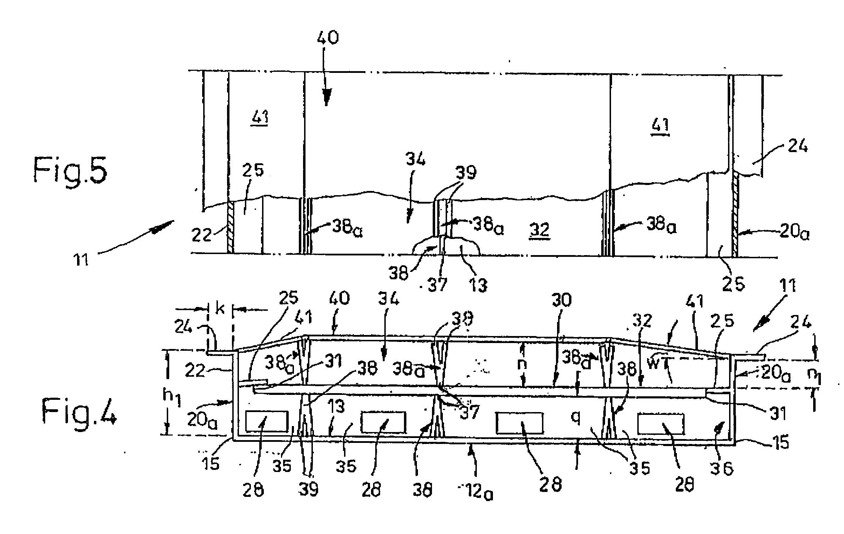

Die in Fig. 4, 5 gezeigte Vorrichtung 11 trägt auf einem plattenförmigen Bodenprofil 12a nahe von dessen Endkanten 15 davon vertikal aufragende Längswandprofile 20a der Höhe h₁, denen jeweils ein nach außen abkragender Firststreifen 24 sowie etwa in der Hälfte der Höhe h₁ ein einwärts gerichteter Kragstreifen 25 angeformt sind. Letztere dienen der Festlegung der Längsränder 31 der OLED-Folie 30, die ihrerseits mit einer in Abstand n parallel gespannten Deckfolie 40 einen Firstraum 34 begrenzt. Das Maß dieses Abstandes n entspricht etwa dem lichten Abstand q zwischen der OLED-Folie 30 und der Oberfläche 13 des Bodenprofils 12a. In dem dadurch begrenzten Basisraum 36 sind auch hier Feuchtigkeitsabsorber 28 angeordnet und zwar in vier Zwischenräumen 35, die von -- die OLED-Folie 30 tragenden - - Abstandhaltern 38 bestimmt werden. Diese sind ebenso von V-förmigem Querschnitt wie die gegenläufigen Abstandhalter 38a zwischen der OLED-Folie 30 sowie der dazu parallelen Deckelfolie 40. Die Abstandshalter 38, 38a fluchten vertikal miteinander, und jeweils eine von ihrer Querschnittspitze bestimmte Endkante 37 verläuft an der OLED-Folie 30. Die am anderen Querschnittsende parallel verlaufenden zwei Querschnittskanten sind mit 39 bezeichnet.

Im Beispiel der Fig. 4 ist der oben erwähnte Abstand n größer als der vertikale Abstand n₁ des inneren Kragstreifens 25 des Längswandprofils 20a von dessen äußerem Firststreifen 24, weshalb zwischen dem Längswandprofil 20a und dem benachbarten Abstandshalter 38a die Deckelfolie 40 mit einem querschnittlichen Randstreifen 41 in einem Winkel w -- beispielsweise 10° -- von einer Knicklinie 42 der Deckelfolie 40 zum Längswandprofil 20a abwärts geneigt ist.

Im übrigen kann statt der Deckelfolie 40 auch eine Glasscheibe zum Einsatz kommen.

Die Erfindung kann auch folgende Merkmale aufweisen bzw. durch nachfolgende Merkmale/Ansprüche beschrieben werden:
1. Vorrichtung für die Herstellung und/oder Aufbewahrung von wasserdampfempfindlichen Elektronikbauteilen, insbesondere von organischen Leuchtdioden oder Solarzellen,
   gekennzeichnet
   durch eine mehrfache Einkapselung, insbesondere durch eine doppelte Einkapselung, welche eine innere Einkapselung für die Elektronikbauteile ergibt.
2. Vorrichtung nach Anspruch 1, **dadurch gekennzeichnet, dass** eine äußere Einkapselung einen Hohlraum bildet, der neben dem/den sich in der zweiten Einkapselung befindlichen Elektronikbauteil/en Feuchtigkeitsabsorberwerkstoff enthält.
3. Vorrichtung nach Anspruch 2, **dadurch gekennzeichnet, dass** der Hohlraum mit inertem Gas gefüllt ist.
4. Vorrichtung nach Anspruch 2, **dadurch gekennzeichnet, dass** der Hohlraum eine Flüssigkeit oder einen Festkörper hoher Wasserdampfleitfähigkeit enthält.
5. Vorrichtung nach einem der Ansprüche 1 bis 4, **dadurch gekennzeichnet, dass** der Hohlraum durch zumindest eine Noppe oder wenigstens einen Steg gebildet ist.
6. Vorrichtung nach Anspruch 5, **dadurch gekennzeichnet, dass** die Noppe/n und/oder der/die Steg/e in ein folienartiges Deckelelement eingeprägt ist/sind.
7. Vorrichtung nach einem der Ansprüche 1 bis 6, **dadurch gekennzeichnet, dass** die äußere Verkapselung aus flexibler Barrierefolie besteht.
8. Vorrichtung nach einem der Ansprüche 1 bis 7, **dadurch gekennzeichnet, dass** die äußere Verkapselung eine anorganische lichttransparente Barriereschicht enthält.
9. Vorrichtung nach einem der Ansprüche 1 bis 8, **dadurch gekennzeichnet, dass** eine transparente Schicht durch ein Vakuumbeschichtungsverfahren aufgebracht ist, insbesondere durch eine Elektronenstrahlverdampfung von Siliziumoxid.
10. Vorrichtung nach einem der Ansprüche 1 bis 9, **dadurch gekennzeichnet, dass** die anorganische Barriereschicht mit einer Lackschicht kombiniert ist, die insbesondere auf Ormoceren basiert.
11. Vorrichtung nach einem der Ansprüche 1 bis 10, gekennzeichnet durch eine Verkapselung der Rückseite mittels einer Metallverbundfolie, insbesondere einer Leichtmetallverbundfolie.
12. Vorrichtung nach einem der Ansprüche 1 bis 11, **dadurch gekennzeichnet, dass** die der Verkapselung dienenden verbundfolien durch thermische Versiegelung oder Ultraschallversiegelung verbunden sind.
13. Vorrichtung nach Anspruch 11 oder 12, gekennzeichnet durch eine für Wasser und/oder Sauerstoff undurchlässige Verbundfolie.
14. Vorrichtung nach einem der Ansprüche 11 bis 13, **dadurch gekennzeichnet, dass** in der verbundfolie Kavitäten zur Aufnahme von Feuchteabsorberwerkstoff durch Kaltumformung hergestellt sind.
15. Vorrichtung nach einem der Ansprüche 1 bis 14, **dadurch gekennzeichnet, dass** die äußere Ein- oder Verkapselung durch Blister hergestellt ist.
16. Vorrichtung nach einem der Ansprüche 1 bis 15, **dadurch gekennzeichnet, dass** in Abstand zu einem wasserempfindlichen Elektronikbauteil (30) einer Vorrichtung eine Glasebene oder eine Deckelfolie (40) gespannt ist.
17. Vorrichtung nach Anspruch 16, **dadurch gekennzeichnet, dass** sie von einem Bodenbereich (12, 12a) aufragende Wände (22) aufweist, auf denen die Deckelfolie (40) festgelegt ist.
18. Vorrichtung nach Anspruch 17, gekennzeichnet durch ein querschnittlich rinnenartiges Bodenprofil (12, 12a), dessen Rinnenränder (16) jeweils mit einem Fußstreifen (18) eines Wandprofils (20) verbunden sind (Fig. 1).
19. Vorrichtung nach Anspruch 18, **dadurch gekennzeichnet, dass** der Rinnenrand (16) mit dem in Abstand benachbarten Wandprofil (20) einen Rinnenraum (26) zur Aufnahme von Feuchtigkeitsabsorbern (28) begrenzt.
20. Vorrichtung nach Anspruch 19, **dadurch gekennzeichnet, dass** die Feuchtigkeitsabsorber (28) als Kastenelemente ausgebildet sind.
21. Vorrichtung nach einem der Ansprüche 18 bis 20, **dadurch gekennzeichnet, dass** zwischen den Rinnenräumen (26) bzw. den in diesen verlaufenden Reihen von Feuchtigkeitsabsorbern oder Kastenelementen (28) ein wasserempfindliches Elektronikbauteil (30) angeordnet ist.
22. Vorrichtung nach einem der Ansprüche 19 bis 21, **dadurch gekennzeichnet, dass** beidseits des wasserempfindlichen Elektronikbauteils (30) die Feuchtigkeitsabsorber (28) angeordnet sind (Fig. 1 bis 3).
23. Vorrichtung nach einem der Ansprüche 16 bis 22, **dadurch gekennzeichnet, dass** das wasserempfindliche Elektronikbauteil (30) zwischen zwei Wandprofilen (20a) in Abstand zu einem diese verbindenden Bodenprofil (12a) angeordnet ist (Fig. 4).
24. Vorrichtung nach Anspruch 16 und 23, **dadurch gekennzeichnet, dass** sowohl zwischen Bodenprofil (12a) und wasserempfindlichem Elektronikbauteil (30) als auch zwischen diesem und der Deckelfolie (40) Abstandshalter (38, 38a) angeordnet sind.
25. Vorrichtung nach Anspruch 24, **dadurch gekennzeichnet, dass** eine von der Querschnittspitze des Abstandhalters (38, 38a) bestimmte Endkante (37) an dem wasserempfindlichem Elektronikbauteil (30) verläuft.
26. Vorrichtung nach einem der Ansprüche 16 bis 25, **dadurch gekennzeichnet, dass** die Deckelfolie (40) nahe dem Gehäuse der Vorrichtung (11) in einem Winkel (w) zum wasserempfindlichen Elektronikbauteil (30) geneigt ist (Fig. 4).
27. Vorrichtung nach Anspruch 24 und 26, **dadurch gekennzeichnet, dass** ein geneigter Randstreifen (41) der Deckelfolie (40) von einer Knicklinie (42) in dieser begrenzt und die Lage dieser Knicklinie durch einen Abstandshalter (38a) bestimmt ist.
28. Vorrichtung nach wenigstens einem der voraufgehenden Ansprüche, gekennzeichnet durch zumindest ein weiteres in der Zeichnung und/oder der Beschreibung offenbartes Merkmal.
29. Verfahren zur Herstellung einer Vorrichtung nach wenigstens einem der voraufgehenden Ansprüche, **dadurch gekennzeichnet, dass** in die äußere Einkapselung eingebrachte Feuchtigkeit von einem eingekapselten Feuchtigkeitsabsorber absorbiert wird.
30. Verfahren nach Anspruch 29, gekennzeichnet durch zumindest ein weiteres in der Zeichnung und/oder der Beschreibung offenbartes Merkmal.

## Patentansprüche

1. Vorrichtung für die Herstellung und/oder Aufbewahrung von wasserdampfempfindlichen Elektronikbauteilen, insbesondere von organischen Leuchtdioden oder Solarzellen, mit einer mehrfachen, insbesondere einer doppelten Einkapselung, wobei eine erste, innere Einkapselung für die Elektronikbauteile vorgesehen ist, die von einer zweiten, äußeren Einkapselung umgeben ist, wobei die äußere Einkapselung aus zwei flexiblen, miteinander verbundenen Folien besteht, wobei zwischen der äußeren Einkapselung und der inneren Einkapselung ein Hohlraum ausgebildet ist und wobei ein Feuchtigkeitsabsorberwerkstoff vorgesehen ist,
**dadurch gekennzeichnet,**
**dass** die beiden Folien der äußeren Einkapselung unmittelbar miteinander verbunden sind.

2. Vorrichtung nach Anspruch 1,
**dadurch gekennzeichnet,**
**dass** die beiden Folien mittels einer thermischen Versiegelung oder durch Ultraschallschweißen miteinander verbunden sind.

3. Vorrichtung nach Anspruch 1 oder 2,
**dadurch gekennzeichnet,**
**dass** die äußere Einkapselung einen Hohlraum bildet, der neben dem/den sich in der inneren Einkapselung befindlichen Elektronikbauteil/en den Feuchtigkeitsabsorberwerkstoff enthält.

4. Vorrichtung nach einem der Ansprüche 1 bis 3,
**dadurch gekennzeichnet,**
**dass** der Hohlraum mit inertem Gas gefüllt ist.

5. Vorrichtung nach einem der Ansprüche 1 bis 4,
**dadurch gekennzeichnet,**
**dass** der Hohlraum eine Flüssigkeit oder einen Festkörper hoher Wasserdampfleitfähigkeit enthält.

6. Vorrichtung nach einem der Ansprüche 1 bis 5,
**dadurch gekennzeichnet,**
**dass** der Hohlraum durch zumindest eine Noppe, wenigstens einen Steg oder Antiblockpartikel gebildet ist.

7. Vorrichtung nach einem der Ansprüche 1 bis 6,
**dadurch gekennzeichnet,**
**dass** die Folien der äußeren Verkapselung als Barrierefolien ausgebildet sind.

8. Vorrichtung nach Anspruch 7,
**dadurch gekennzeichnet,**
**dass** die äußere Verkapselung eine anorganische lichttransparente Barriereschicht enthält.

9. Vorrichtung nach einem der Ansprüche 7 oder 8,
**dadurch gekennzeichnet,**
**dass** eine transparente Schicht der Verbundfolie durch ein Vakuumbeschichtungsverfahren aufgebracht ist, insbesondere durch eine Elektronenstrahlverdampfung von Siliziumoxid.

10. Vorrichtung nach einem der Ansprüche 7 bis 9,
**dadurch gekennzeichnet,**
**dass** die die Verbundfolie eine anorganische Barriereschicht aufweist, die mit einer Lackschicht kombiniert ist, die insbesondere auf Ormoceren basiert.

11. Vorrichtung nach einem der Ansprüche 7 bis 10,
**dadurch gekennzeichnet,**
**dass** die Rückseite der äußeren Einkapselung eine Metallverbundfolie, insbesondere eine Leichtmetallverbundfolie, aufweist.

12. Vorrichtung nach einem der Ansprüche 7 bis 11,
**dadurch gekennzeichnet,**
**dass** die Verbundfolie für Wasser und/oder Sauerstoff undurchlässig ausgebildet ist.

13. Vorrichtung nach einem der Ansprüche 1 bis 12,
**dadurch gekennzeichnet,**
**dass** der Feuchtigkeitsabsorberwerkstoff auf eine die Rückseite der Vorrichtung bildenden Folie der äußeren Einkapselung aufgebracht ist.

14. Vorrichtung nach einem der Ansprüche 7 bis 12,
**dadurch gekennzeichnet,**
**dass** der Feuchtigkeitsabsorberwerkstoff in eine die Rückseite der vorrichtung bildenden Folie der äußeren Einkapselung eingearbeitet ist.
